# EUROPEAN PATENT APPLICATION

(11) **EP 4 279 931 A1**
(43) Date of publication of application: **22.11.2023**
(21) Application number: 22174724.9
(22) Date of filing: 21.05.2022
(51) Int. Cl.: G01R 31/3185

(54) **METHOD AND APPARATUS FOR DYNAMICALLY FORMING SCAN CHAINS**

(71) Applicant: NXP B.V., 5656 AG Eindhoven (NL)
(72) Inventor: SRIVASTAVA, Neha, 201301 Noida (IN); TIKOO, Gautam, 201301 Noida (IN); SHARMA, Ajay, 201301 Noida (IN)
(74) Representative: Hardingham, Christopher Mark

(57) **Abstract**

The disclosure relates to self-testing of logic modules in an integrated circuit (IC) using a logic built-in self-test (LBIST) controller. In an example embodiment, an IC (400) comprises: an LBIST controller (401); a plurality of logic modules (402-406); a plurality of demultiplexers (407₁₋₃); a plurality of multiplexers (408₁₋₄), each demultiplexer (407₁₋₃) configured to receive a scan chain output from a respective one of the plurality of logic modules (402-406) and provide the scan chain output to a selected multiplexer (408₁₋₄) dependent on a demultiplexer input signal, each multiplexer (408₁₋₄) configured to receive a selected scan chain output from a subset of the plurality of demultiplexers (407₁₋₃) and to provide a scan chain input to a respective one of the plurality of logic modules (402-406) dependent on a multiplexer input signal, the LBIST controller (401) configured to perform a scan chain test on a selected subset of the logic modules by providing a scan chain input to a first one of the plurality of logic modules (402-406) and selection signals to the demultiplexers (407₁₋₃) and multiplexers (408₁₋₄) to define a scan chain path (411, 412) from the first one (402) of the plurality of logic modules (402-406) through the selected subset of logic modules.

## Description

### Field

The disclosure relates to self-testing of an integrated circuit (IC) using a logic built-in self-test (LBIST) controller.

### Background

Built-in self-test (BIST) schemes enable a system comprising one or more integrated circuits to test itself, i.e. without requiring external test equipment to determine whether the system is operating correctly. A BIST scheme may also enable testing of device circuitry that is otherwise not accessible to external test equipment. Logic BIST (LBIST) is a form of BIST in which the corresponding hardware and/or software is built into the IC to enable the IC to test its own operation. LBIST schemes typically involve performing scan tests on chains of logic partitions within an IC, the scan tests being arranged sequentially such that outputs from one scan chain are provided to inputs of a subsequent scan chain.

A problem with existing LBIST schemes using scan chains is that physically co-located logic partitions are linked together and scanned in series, requiring all logic partitions to be tested and reset, even if only some partitions are required to be tested for use.

### Summary

According to a first aspect there is provided an integrated circuit (IC) comprising:
a logic built-in self-test (LBIST) controller;
a plurality of logic modules;
a plurality of demultiplexers;
a plurality of multiplexers,
each demultiplexer configured to receive a scan chain output from a respective one of the plurality of logic modules and provide the scan chain output to a selected multiplexer dependent on a demultiplexer input signal,
each multiplexer configured to receive a selected scan chain output from a subset of the plurality of demultiplexers and to provide a scan chain input to a respective one of the plurality of logic modules dependent on a multiplexer input signal,
the LBIST controller configured to perform a scan chain test on a selected subset of the logic modules by providing a scan chain input to a first one of the plurality of logic modules and selection signals to the demultiplexers and multiplexers to define a scan chain path from the first one of the plurality of logic modules through the selected subset of logic modules and providing a scan chain input to a first one of the plurality of logic modules.

The arrangement allows for a scan chain path to be defined with an arbitrarily selected subset of logic modules, enabling different subsets of logic modules to be linked together according to requirements of software to be executed on the IC.

The LBIST controller may be configured to provide first selection signals to the multiplexers and demultiplexers to define a first scan chain path through a first subset of the plurality of logic modules and second selection signals to the multiplexers and demultiplexers to define a second scan chain path through a second subset of the plurality of logic modules, the first scan chain path containing a different subset of logic modules to those in the second scan chain path.

Each of the plurality of logic modules may comprise a reset module configured to receive a reset signal from the LBIST controller, the IC comprising an LBIST reset controller configured to provide a reset signal to each reset module in the selected subset of logic modules after performing the scan chain test for the selected subset of logic modules. The reset signals may be provided through the defined scan chain path, i.e. routed through the demultiplexers and multiplexers defining the scan chain path.

The LBIST controller may comprise the LBIST reset controller.

The IC may comprise an environment controller configured to provide control signals to the LBIST controller to define the selection signals to the demultiplexers and multiplexers according to software to be executed on the IC.

Each of the plurality of logic modules may comprise a logic isolation element configured to receive a safe state enable signal and to provide an output signal dependent on the safe state enable signal, the LBIST controller configured to provide a safe state enable signal to each logic isolation element in the selected subset of logic modules. The safe state of each isolation module are configurable through the existing scan chain. This allows for better control of value and configurability based on the application running on the logic modules and the way the modules interact with other groups of modules.

According to a second aspect there is provided a method of operating an integrated circuit comprising a logic built-in self-test (LBIST) controller, a plurality of logic modules and a plurality of demultiplexers and multiplexers connecting pairs of logic modules, the method comprising:
the LBIST controller performing a self-test operation on a subset of the plurality of logic modules by providing a scan chain input to a first one of the plurality of logic modules and providing selection signals to the demultiplexers and multiplexers to define a scan chain path from the first one of the plurality of logic modules through remaining ones of the subset of logic modules.

The LBIST controller may provide first selection signals to the multiplexers and demultiplexers defining a first scan chain path through a first subset of the plurality of logic modules. The LBIST controller may provide second selection signals to the multiplexers and demultiplexers defining a second scan chain path through a second subset of the plurality of logic modules, the first scan chain path containing a different subset of logic modules to those in the second scan chain path.

The method may further comprise an LBIST reset controller providing a reset signal to each logic module in the LBIST scan chain following the self-test operation. The reset signals may be provided through the scan chain path, i.e. routed through the demultiplexers and multiplexers defining the scan chain path. The LBIST controller may comprise the LBIST reset controller.

The IC may comprise an environment controller that provides control signals to the LBIST controller defining the selection signals provided to the demultiplexers and multiplexers according to software to be executed on the IC.

These and other aspects of the invention will be apparent from, and elucidated with reference to, the embodiments described hereinafter.

### Brief description of Drawings

Embodiments will be described, by way of example only, with reference to the drawings, in which:
Figure 1 is a schematic illustration of an example IC with multiple logic partitions;
Figures 2 and 3 are schematic illustrations of an example IC with multiple physical partitions each with multiple logic modules operating and connected according to different virtual applications;
Figure 4 is a schematic illustration of a plurality of logic modules operating under control of an LBIST controller;
Figure 5 is a schematic diagram of an LBIST controller and a chain of logic elements;
Figure 6 is a flow diagram illustrating an example method of performing a self-test operation on an IC; and
Figure 7 is a flow diagram illustrating an example method of operating a dynamically reconfigurable IC.

It should be noted that the Figures are diagrammatic and not drawn to scale. Relative dimensions and proportions of parts of these Figures have been shown exaggerated or reduced in size, for the sake of clarity and convenience in the drawings. The same reference signs are generally used to refer to corresponding or similar feature in modified and different embodiments.

### Detailed description of embodiments

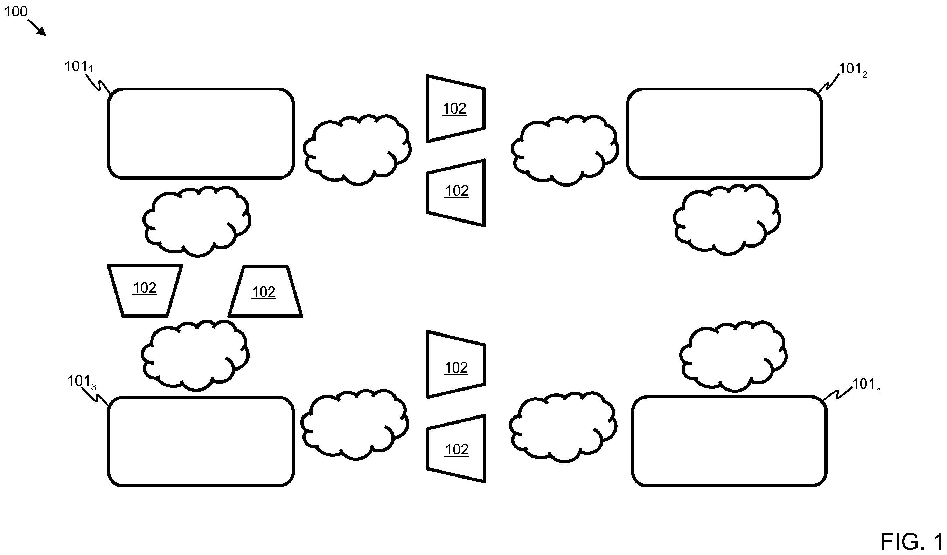

Figure 1 illustrates an example conventional IC 100 with multiple logic partitions 101₁₋ₙ. Many more such partitions may also typically be present in the IC 100, the number illustrated being used only as an example. The logic partitions 101₁₋ₙ are separated from each other by isolation logic 102, which hardens the boundaries between the logic partitions 101₁₋ₙ. In a conventional implementation, partitions 101₁, 101₃ may be each isolated from partitions 101₂, 101ₙ with static isolation logic 102. In a dynamic implementation, in which a change in the operating environment may be required according to changing processing requirements, partitions 101₂, 101₃ may be required to work together, but this would not be possible due to there being no isolation logic between partitions 101₂, 101ₙ. A context switch to partitions 101₁, 101₂ operating together would result in redundant hardcoded isolation logic 102 being present between the partitions. A further disadvantage is that the value of the isolation between the partitions may be incorrect, depending on the context of the application.

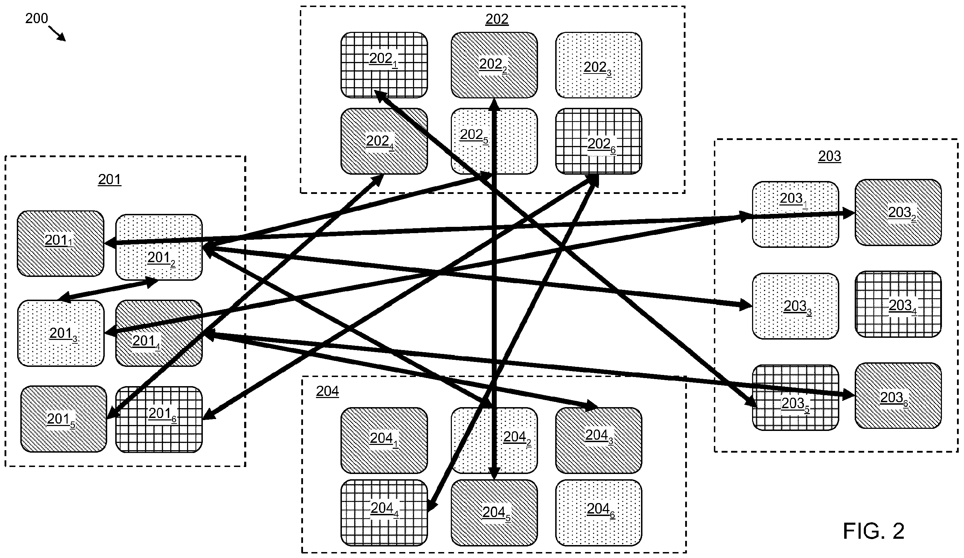

Figure 2 illustrates an example IC 200 with multiple physical partitions 201, 202, 203, 204. Each physical partition 201-204 contains multiple logic modules 201₁₋₆, 202₁₋₆, 203₁₋₆, 204₁₋₆, each logic module representing the lowest granularity of functionality for which a scan chain cannot be further fragmented. Each logic module can be individually initialized or reset. The functionality of each logic modules is indicated according to its shading. In the first physical partition 201 for example, logic modules 201₁, 201₄, 201₅ operate and interact together according to a virtual application that requires the functionality of these logic modules. Logic modules 201₂, 201₃ operate according to a different virtual application and logic module 201₆ operates according to another different virtual application. Interaction between logic modules, both within each physical partition and between different physical partitions, is indicated by arrows in Figure 2, with logic modules communicating with other logic modules of the same virtual application.

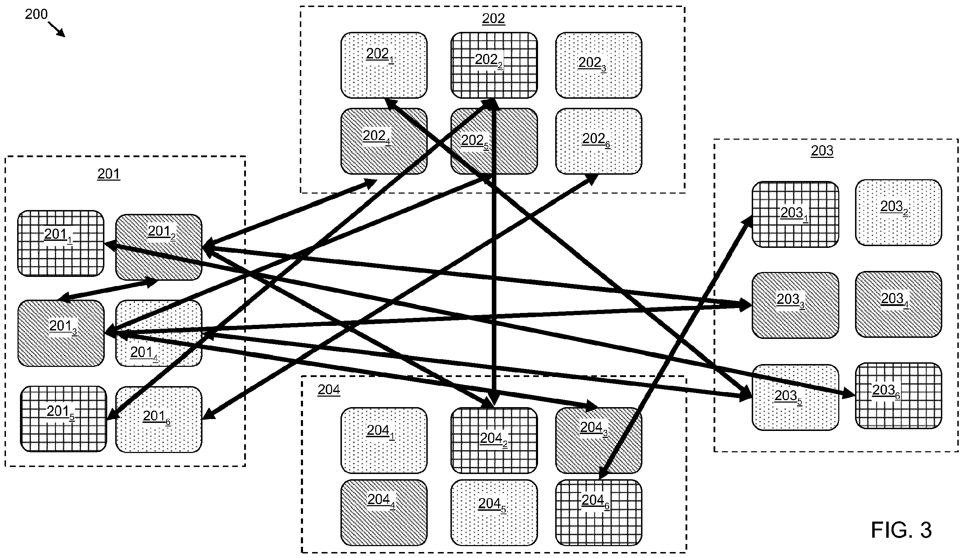

The arrangement in Figure 2 allows for the arrangement of connections between logic modules to be rearranged according to the requirements of the applications being implemented on the IC 200. Figure 3 illustrates an example of the IC 200 with different arrangements of logic modules, in which for example in physical partition 201 logic modules 201₂, 201₃ operate according to one virtual application, logic modules 201₁, 201₅ operate to another virtual application and logic modules 201₄, 201₆ operate to another virtual application. The connections between the various logic modules within and between the physical partitions 201-204 changes accordingly.

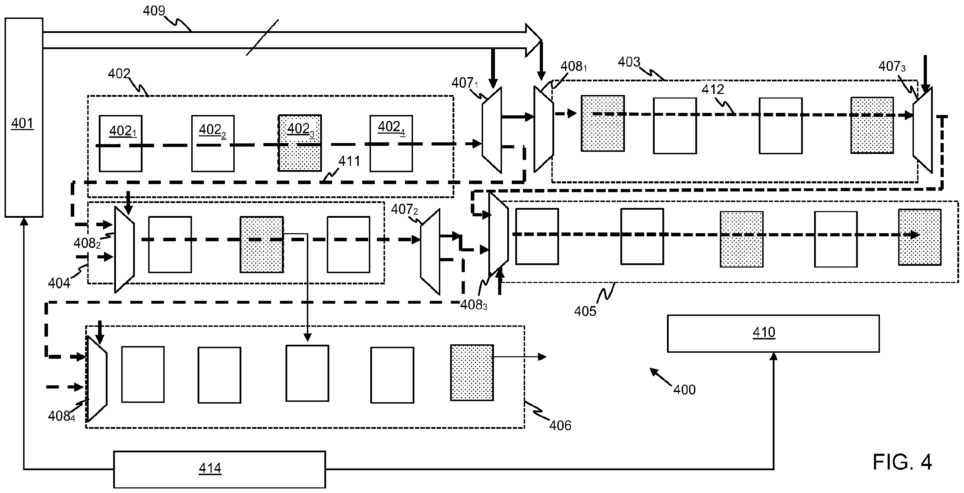

Figure 4 illustrates an example integrated circuit 400 comprising a logic built-in self-test (LBIST) controller 401 and a plurality of logic modules 402-406. The logic modules 402-406 are connected by a plurality of demultiplexers 407₁₋₃ and a plurality of multiplexers 408₁₋₄. Each demultiplexer 407₁₋₃ is configured to receive a scan chain output from a respective one of the plurality of logic modules 402-406 and provide the scan chain output to a selected multiplexer 408₁₋₄ dependent on a demultiplexer input signal. Each multiplexer 408₁₋₄ is configured to receive a selected scan chain output from a subset of the plurality of demultiplexers 407₁₋₃ and to provide a scan chain input to a respective one of the plurality of logic modules 402-406 dependent on a multiplexer input signal. For clarity, only a selected number of possible connections are illustrated in Figure 4. In a typical implementation, many more connections between the demultiplexers 407₁₋₃ and multiplexers 408₁₋₄ will be available. Also, many more logic modules than that shown will typically be available in an implementation.

The LBIST controller 401 is configured to perform a scan chain test on a selected subset of the logic modules 402-406 by providing a scan chain input to a first one 402 of the plurality of logic modules 402-406 and selection signals to the demultiplexers 407₁₋₃ and multiplexers 408₁₋₄ to define a scan chain path from the first one 402 of the plurality of logic modules 402-406 through the selected subset of logic modules. Data output from a scan chain path is provided to a multiple input signature register (MISR, not shown in Figure 4) and compared by the LBIST controller 401 to data that is expected to be output by the scan chain path, the scan chain test passing if the output data matches the expected data.

In the example shown in Figure 4, two different scan chain paths 411, 412 are shown: a first scan chain path 411 passing through logic modules 402, 404, 406 and a second scan chain path 412 passing through logic modules 402, 403, 405. Selection signals are provided by the LBIST controller 401 via a multiplexer/demultiplexer bus 409 to each of the multiplexers 408₁₋₄ and demultiplexers 407₁₋₃ to define a selected scan chain path 411, 412. A scan chain test may thereby be performed on a selected subset of the logic modules 402-406. The effect therefore is to allow logic partitions to be defined dynamically according to the requirements of a particular application, each logic partition comprising the logic modules that are required for the application. In the example of Figure 4, a first logic partition is defined by logic modules 402, 404, 406 and a second logic partition is defined by logic modules 402, 403, 405.

An IC 400 of the type illustrated in Figure 4 may be reconfigurable to connect relevant scan chains for a particular application, with groups of 'mini-chains' determined by the functionality required according to the software to be executed. An advantage of this arrangement is in maximising the availability and minimising on run time and power requirements because only the relevant logic modules are selected to undergo self-testing and reset.

Each logic module contains multiple logic elements including one or more elements that are configured to perform selective isolation of the logic partition. Each logic element may for example be a flip-flop or another sequential logic element. As illustrated by example in Figure 4, logic module 402 comprises multiple logic elements 402₁₋₄, of which logic element 402₃ is configured to perform isolation of the logic partition 402.

A configurable LBIST reset controller 410, which may optionally be part of the LBIST controller, may also be provided, the LBIST reset controller 410 being configured to provide a reset signal to a selected subgroup of logic modules following a scan chain test being performed on the selected subgroup. The reset signal may be provided via the selected scan chain via the multiplexers and demultiplexers. Each logic module 402-406 has a dedicated reset port. Reset port assertion by the LBIST reset controller 410 may be controlled via software depending on the application environment. The LBIST reset controller 410 may therefore be configured to provide reset signals to a selected subgroup of logic modules corresponding to the scan chain test performed on the selected subgroup. The reset signals may be provided via the scan chain, i.e. via the demultiplexers and multiplexers.

An environment controller 414 provides control signals to the LBIST controller 401 and reset controller 410 (if separate from the LBIST controller) to define the selection signals to the demultiplexers and multiplexers according to the software to be executed on the IC, which enables the LBIST controller 401 and reset controller 410 to select the appropriate subgroup of logic modules.

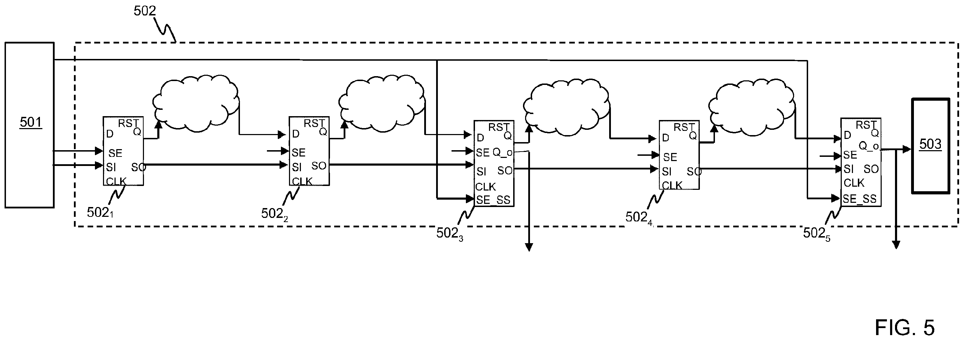

A configurable isolation scheme may be built into each mini chain to support dynamic software driven inter-logic interactions. An example of this is illustrated in Figure 5, which shows an LBIST controller 501 providing signals to a chain 502 of logic elements 502₁₋₅. An output of the chain 502 is provided to an MISR block 503, the output being driven by a Q_o port of a safe stating logic element 502₅. The chain 502 comprises two safe stating logic elements 502₃, 502₅, both of which are provided with a safe state enablement input signal SE_SS by the LBIST controller 501. Each safe stating logic element 502₃, 502₅ operates according to the logic table below. When enabled, the safe state enablement input signal SE_SS holds the Q_o output to the previous value when in either scan mode or capture mode. When disabled, the safe state enablement input signal SE_SS causes the Q_o output to equal the D input in functional mode and to equal the SI input in the safe state enablement mode.

**Table 1 - Logic table for safe state enablement logic element.**

| **Phase** | **SE** | **SE SS** | **Q** | **Q o** |
|---|---|---|---|---|
| Func Mode | 0 | 0 | D | D |
| Scan | 1 | 1 | D | Held to previous value |
| Safe State Enablement | 1 | 0 | D | Si |
| Capture | 0 | 1 | D | Held to previous value |

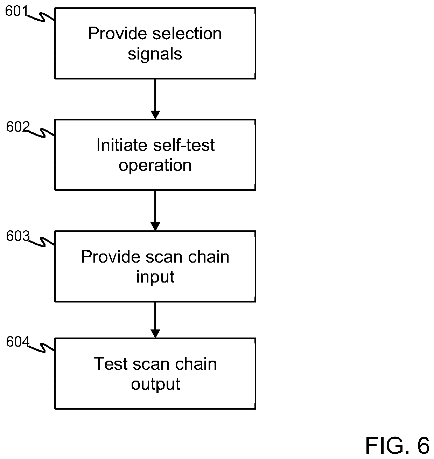

Figure 6 illustrates an example flow chart of a method of operating an IC as described herein. In a first step 601, selection signals are provided to multiplexers and demultiplexers to define a scan chain path through a subset of the logic modules, for example in response to a change in software to be executed. In a second step 602, a self-test operation is initiated. In step 603, a scan chain input is provided to a first one of the plurality of logic modules in the defined scan chain. In step 604, a scan chain output from the defined scan chain is tested, for example using an MISR as defined above.

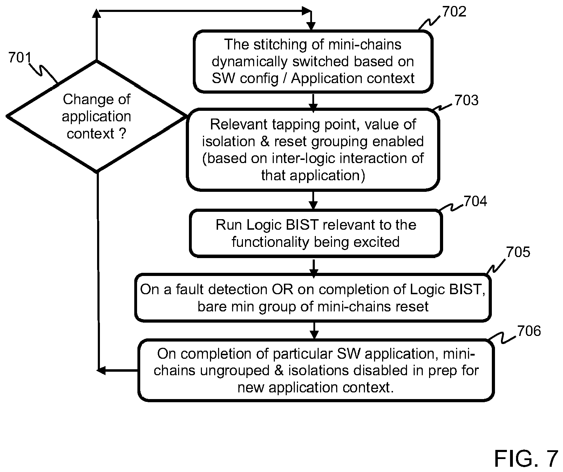

Figure 7 illustrates a further flow chart of a more general method of operating the IC covering a change of application, i.e. in which logic modules in the IC are selected to operate different software. With a change of application 701, selected groups of logic modules are dynamically stitched together (step 702) as mini-chains based on the software configuration or application context. In step 702, the relevant tapping point, isolation value and reset grouping are enabled based on inter-logic interaction of the application. In step 703, the logic BIST is run that is relevant to the functionality being excited, i.e. following the method described above in relation to Figure 6. In step 704, on fault detection or on completion of the logic BIST, the bare minimum group of mini-chains is reset. In step 705, on completion of a particular software application, the mini-chains are ungrouped and isolations are disabled in preparation for the new application context. The process then repeats at step 701 for a new application.

From reading the present disclosure, other variations and modifications will be apparent to the skilled person. Such variations and modifications may involve equivalent and other features which are already known in the art of integrated circuit design, and which may be used instead of, or in addition to, features already described herein.

Although the appended claims are directed to particular combinations of features, it should be understood that the scope of the disclosure of the present invention also includes any novel feature or any novel combination of features disclosed herein either explicitly or implicitly or any generalisation thereof, whether or not it relates to the same invention as presently claimed in any claim and whether or not it mitigates any or all of the same technical problems as does the present invention.

Features which are described in the context of separate embodiments may also be provided in combination in a single embodiment. Conversely, various features which are, for brevity, described in the context of a single embodiment, may also be provided separately or in any suitable sub-combination. The applicant hereby gives notice that new claims may be formulated to such features and/or combinations of such features during the prosecution of the present application or of any further application derived therefrom.

For the sake of completeness it is also stated that the term "comprising" does not exclude other elements or steps, the term "a" or "an" does not exclude a plurality, a single processor or other unit may fulfil the functions of several means recited in the claims and reference signs in the claims shall not be construed as limiting the scope of the claims.

## Claims

1. An integrated circuit (400), IC, comprising:
a logic built-in self-test, LBIST, controller (401);
a plurality of logic modules (402-406);
a plurality of demultiplexers (407₁₋₃);
a plurality of multiplexers (408₁₋₄),
each demultiplexer (407₁₋₃) configured to receive a scan chain output from a respective one of the plurality of logic modules (402-406) and provide the scan chain output to a selected multiplexer (408₁₋₄) dependent on a demultiplexer input signal,
each multiplexer (408₁₋₄) configured to receive a selected scan chain output from a subset of the plurality of demultiplexers (407₁₋₃) and to provide a scan chain input to a respective one of the plurality of logic modules (402-406) dependent on a multiplexer input signal,
the LBIST controller (401) configured to perform a scan chain test on a selected subset of the logic modules by providing selection signals to the demultiplexers (407₁₋₃) and multiplexers (408₁₋₄) to define a scan chain path (411, 412) from the first one (402) of the plurality of logic modules (402-406) through the selected subset of logic modules and providing a scan chain input to a first one of the plurality of logic modules (402-406).

2. The IC (400) of claim 1, wherein the LBIST controller (401) is configured to provide first selection signals to the multiplexers (407₁₋₃) and demultiplexers (408₁₋₄) to define a first scan chain path (411) through a first subset (402, 404, 406) of the plurality of logic modules (402-406) and second selection signals to the multiplexers (407₁₋₃) and demultiplexers (407₁₋₄) to define a second scan chain path (412) through a second subset (402, 403, 405) of the plurality of logic modules (402-406), the first scan chain path (411) containing a different subset of logic modules to those in the second scan chain path (412).

3. The IC (400) of claim 1 or claim 2, comprising an LBIST reset controller (410), wherein each of the plurality of logic modules (402-406) is configured to receive a reset signal from the LBIST controller, the LBIST reset controller (410) configured to provide a reset signal to each logic module in the selected subset of logic modules after performing the scan chain test for the selected subset of logic modules.

4. The IC (400) of claim 3, wherein the LBIST reset controller (410) is configured to provide the reset signal to each logic module in the selected subset of logic modules through the defined scan chain path.

5. The IC (400) of claim 3 or claim 4, wherein the LBIST controller (401) comprises the LBIST reset controller (410).

6. The IC (400) of any preceding claim, comprising an environment controller (414) configured to provide control signals to the LBIST controller (401) to define the selection signals to the demultiplexers (407₁₋₃) and multiplexers (408₁₋₄) according to software to be executed on the IC (400).

7. The IC (400) of any preceding claim, wherein each of the plurality of logic modules (402-406, 502) comprises an logic isolation element (502₅) configured to receive a safe state enable signal (SE_SS) and to provide an output signal (Q_o) dependent on the safe state enable signal (SE_SS), the LBIST controller (501) configured to provide a safe state enable signal (SE_SS) to each logic isolation element (502₅) in the selected subset of logic modules.

8. A method of operating an integrated circuit (400), IC, comprising a logic built-in self-test, LBIST, controller (401), a plurality of logic modules (402-406) and a plurality of demultiplexers (407₁₋₃) and multiplexers (408₁₋₄), the method comprising:
the LBIST controller (401) performing a self-test operation on a subset of the plurality of logic modules (402-406) by providing a scan chain input to a first one (402) of the plurality of logic modules and providing selection signals to the demultiplexers (407₁₋₃) and multiplexers (408₁₋₄) to define a scan chain path from the first one (402) of the plurality of logic modules through remaining ones of the subset of logic modules (402-406).

9. The method of claim 8, wherein the LBIST controller (401) provides first selection signals to the multiplexers (407₁₋₃) and demultiplexers (408₁₋₄) defining a first scan chain path (411) through a first subset (402, 404, 406) of the plurality of logic modules (402-406)

10. The method of claim 9, wherein the LBIST controller (401) provides second selection signals to the multiplexers (407₁₋₃) and demultiplexers (407₁₋₄) defining a second scan chain path (412) through a second subset (402, 403, 405) of the plurality of logic modules (402-406), the first scan chain path (411) containing a different subset of logic modules to those in the second scan chain path (412).

11. The method of claim any one of claims 8 to 10, wherein the IC (400) further comprises an LBIST reset controller (410) providing a reset signal to each logic module in the LBIST scan chain following the self-test operation.

12. The method of claim 11, wherein the LBIST reset controller (410) provides the reset signal to each logic module in the selected subset of logic modules through the selected scan chain path.

13. The method of claim 11 or claim 12, wherein the LBIST controller (401) comprises the LBIST reset controller (410).

14. The method of any one of claims 8 to 13, wherein the IC (400) comprises an environment controller (414), the environment controller (414) providing control signals to the LBIST controller (401) defining the selection signals provided to the demultiplexers (407₁₋₃) and multiplexers (408₁₋₄) according to software to be executed on the IC (400).
